# EUROPEAN PATENT APPLICATION

(11) **EP 4 535 600 A1**
(43) Date of publication of application: **09.04.2025**
(21) Application number: 23811389.8
(22) Date of filing: 06.03.2023
(51) Int. Cl.: H02J 7/00, H02H 3/05, H02M 3/155, H02M 3/28

(54) **POWER SUPPLY DEVICE AND SWITCH DIAGNOSIS METHOD**

(30) Priority: 27.05.2022 JP 2022086661
(71) Applicant: PANASONIC INTELLECTUAL PROPERTY MANAGEMENT CO., LTD., Kadoma-shi Osaka 571-0057 (JP)
(72) Inventor: TAKEMOTO, Kensuke, Kadoma-shi, Osaka 571-0057 (JP); YOSHIDA, Koji, Kadoma-shi, Osaka 571-0057 (JP); NAKAYASHIKI, Takeshi, Kadoma-shi, Osaka 571-0057 (JP)
(74) Representative: Novagraaf International SA
(86) International application number: PCT/JP2023/008224
(87) International publication number: WO 2023/228508

(57) **Abstract**

A power supply device is configured to be connected between first and second DC power supplies. The power supply device includes a first switch having one end connected to the first DC power supply, a DC-DC converter including a first capacitor connected to another end of the first switch, and a controller configured to control the DC-DC converter and the first switch and detect a potential difference between the one and another ends of the first switch. The DC-DC converter is configured to perform at least one of: a first operation converting a voltage stored in the first capacitor to the second voltage and outputting the second voltage to the second DC power supply; or a second operation of converting the second voltage supplied and held by the second DC power supply to a third voltage, and outputting the third voltage to the first capacitor. The controller is configured to: detect the potential difference after instructing the first switch to be turned off and after causing the DC-DC converter to perform the first operation or the second operation; and determine that the first switch is normal when the potential difference detected is greater than a first reference potential difference.

## Description

### TECHNICAL FIELD

The present disclosure relates to a power supply device configured to be connected between two DC power supplies, and to a diagnosis method for a switch in the power supply device.

### BACKGROUND ART

A power supply device connected between two DC power supplies (first DC power supply and second DC power supply) so as to convert power, may include a DC-DC converter converting a voltage on an input side (i.e., first DC power supply) into a desired voltage and output (i.e., charge) the desired voltage to an output side (i.e., second DC power supply). In this type of power supply device, a switch to connect and disconnect a component on the input side from the DC-DC converter and a switch to connect and disconnect a component on the output side from the DC-DC converter are provided in order to protect these two components connected at both ends. In particular, a state whether the switch can be turned off (i.e., switch is normal) is determined by measuring a potential difference between both ends of the switch after the switch is turned off.

Such a conventional technology is disclosed in PTL 1.

### CITATION LIST

### Patent Literature

PTL 1: WO 2019/077958

### SUMMARY OF INVENTION

In a conventional power supply device, a switch is turned off and then a potential difference between both ends of the switch is measured in order to diagnose a turned-off of the switch. In other words, it is determined that the turned-off performance of the switch is normal when the potential difference between both ends of the switch is greater than a reference potential difference, and the turned-off performance of the switch is not normal when the potential difference is not greater than the reference potential difference.

However, when a charge is accumulated inside a DC-DC converter (hereinafter also referred to as "internal charge), the potential difference between both ends of the switch may be small due to a voltage associated with accumulation of the internal charge although the switch is properly responding to an instruction of turning off and being turned off. As a result, a turned-off state of the switch may not be properly diagnosed.
a leak current from a resistor in the DC-DC converter or a decrease in the internal charge due to spontaneous discharge is used for properly diagnosing the turned-off state of the switch. In this method, however, it may take time to discharge the internal charge of the DC-DC converter, and a long standby time may be necessary for determining the turned-off state of the switch.

Furthermore, although a voltage on an input side or an output side is held by a capacitor and the switch is properly responding to the turning-off instruction and is turned off, the potential difference between both ends of the switch may be small when the voltage on the input side or the output side is equal to a ground potential and an internal voltage of the DC-DC converter is also equal to the ground potential. In this case, the turned-off performance of the switch may be hardly diagnosed based on the potential difference between both ends of the switch.

In order to properly diagnose the turned-off state of the switch in the above cases, the turned-off state of the switch may be diagnosed by turning off the switch after increasing the voltage on the input side or the output side by the power supply device and then waiting for the leak current from the resistor in the DC-DC converter or a decrease in the internal charge by spontaneous discharge. However, this method may require a long time until the internal charge of the DC-DC converter is discharged. As a result, a long standby time may be necessary for determining the turned-off state of the switch before starting an operation of the power supply device.

An object of the present disclosure may provide a power supply device and a switch diagnosis method that are capable of diagnosing, in a short period of time, the turned-off performance of the switch provided between the input side or the output side and a DC-DC converter in the power supply device.

A power supply device according to one aspect of the present disclosure is configured to be connected between a first direct-current (DC) power supply and a second DC power supply. The first DC power supply is configured to supply and hold a first voltage. The second DC power supply is configured to supply and hold a second voltage. The power supply device includes a first switch having one end connected to the first DC power supply, a DC-DC converter including a first capacitor connected to another end of the first switch, and a controller configured to control the DC-DC converter and the first switch and detect a potential difference between the one end and the another end of the first switch. The DC-DC converter is configured to perform at least one of: a first operation converting a voltage stored in the first capacitor to the second voltage and outputting the second voltage to the second DC power supply; or a second operation of converting the second voltage supplied and held by the second DC power supply to a third voltage, and outputting the third voltage to the first capacitor. The controller is configured to: detect the potential difference after instructing the first switch to be turned off and after causing the DC-DC converter to perform the first operation or the second operation; and determine that the first switch is normal when the potential difference detected is greater than a first reference potential difference.

In a diagnosis method for the above-described power supply device according to one aspect of the present disclosure, a potential difference between the one end and the another end of the switch is detected after instructing the switch to be turned off and after causing the DC-DC converter to perform the first operation or the second operation. It is determining that the switch is normal when the potential difference detected is greater than a reference potential difference.

The present disclosure provides the power supply device and the switch diagnosis method that are capable of diagnosing, in a short period of time, the turned-off performance of the switch provided between the input side or the output side and the DC-DC converter in the power supply device.

### BRIEF DESCRIPTION OF DRAWINGS

FIG. 1A illustrates a configuration of a power supply device according to an exemplary embodiment.
FIG. 1B is a flow chart illustrating a process of diagnosing a turned-off performance of a first switch in an operation of the power supply device according to the embodiment.
FIG. 1C is a flow chart illustrating a process of diagnosing turned-off performance of a second switch in the operation of the power supply device according to the embodiment.
FIG. 2 illustrates a configuration example of a power supply device according to Modification 1 of the embodiment.
FIG. 3 illustrates a configuration example of a power supply device according to Modification 2 of the embodiment.
FIG. 4 illustrates a configuration example of a power supply device according to Modification 3 of the embodiment.
FIG. 5 illustrates a configuration example of a power supply device according to Modification 4 of the embodiment.
FIG. 6 illustrates a configuration example of a power supply device according to Modification 5 of the embodiment.
FIG. 7 illustrates a circuit of a DC-DC converter according to Example 1 of the power supply device according to the embodiment.
FIG. 8 illustrates a circuit of a DC-DC converter according to Example 2 of the power supply device according to the embodiment.
FIG. 9 illustrates a circuit of a DC-DC converter according to Example 3 of the power supply device according to the embodiment.

### DESCRIPTION OF EMBODIMENT

An exemplary embodiment of the present disclosure will be described below with reference to the drawings. The exemplary embodiment disclosed herein is illustrative and not restrictive.

Still more, detailed description more than necessary may be omitted in the exemplary embodiment described below. For example, detailed description of known items and duplicate description of substantially equivalent components may be omitted. This is to avoid unnecessary redundancy of the description for easier understanding of persons skilled in the art. Furthermore, "A and B are connected to each other" signifies that A is electrically connected to B and includes states in which A and B are indirectly connected to each other via other circuit components between A and B, in addition to a case where A and B are directly connected to each other.

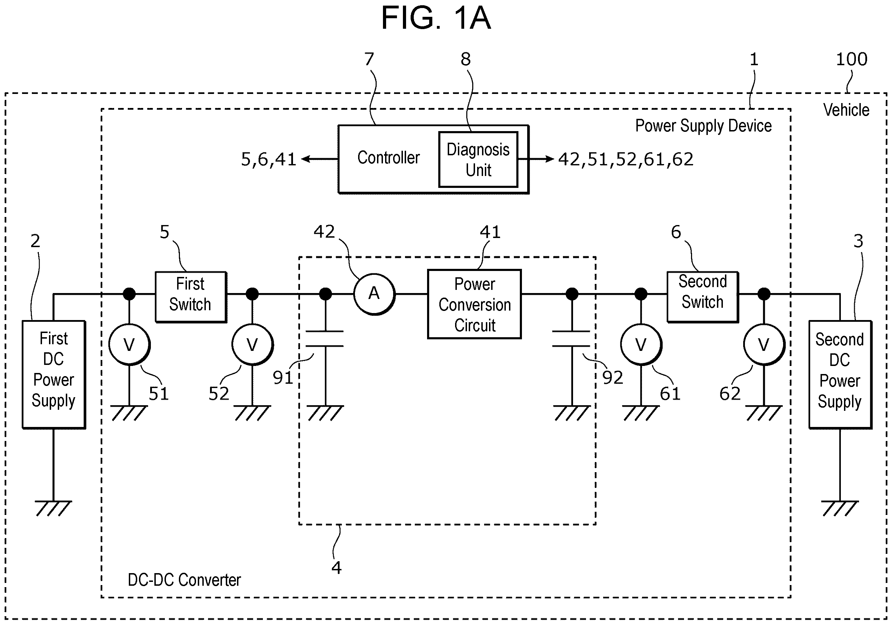

FIG. 1A is a block diagram of power supply device 1 according to an exemplary embodiment. In the present embodiment, power supply device 1 is installed in vehicle 100. As illustrated in FIG. 1A, power supply device 1 according to the embodiment includes first direct-current (DC) power supply 2, second DC power supply 3, DC-DC converter 4, first switch 5, second switch 6, controller 7, first voltage detector 51, second voltage detector 52, third voltage detector 61, and fourth voltage detector 62. Controller 7 includes diagnosis unit 8.

For convenience of description, controller 7 includes diagnosis unit 8. However, controller 7 and diagnosis unit 8 may be separate components. Still more, first voltage detector 51, second voltage detector 52, third voltage detector 61, and fourth voltage detector 62 may be installed in diagnosis unit 8.

First DC power supply 2 is configured to output (i.e., supply and hold) a first voltage. For example, first DC power supply 2 is a battery. Second DC power supply 3 is configured to output (supply and hold) a second voltage. For example, second DC power supply 3 is an electric double-layer capacitor.

DC-DC converter 4 is connected between first DC power supply 2 and second DC power supply 3. DC-DC converter 4 includes first capacitor 91 configured to store the first voltage, second capacitor 92 configured to store the second voltage, current sensor 42 configured to measure current flowing in DC-DC converter 4, and power conversion circuit 41 configured to perform DC voltage conversion to step down the first voltage to the second voltage and DC voltage conversion to boost the second voltage to the first voltage.

DC-DC converter 4 step down the first voltage input from first DC power supply 2, and outputs the stepped-down voltage to second DC power supply 3. In addition, DC-DC converter 4 boosts the second voltage input from second DC power supply 3 and outputs the boosted voltage to first DC power supply 2. In accordance with the present embodiment, DC-DC converter 4 steps down the first voltage input from first DC power supply 2 so as to output the stepped-down voltage to second DC power supply 3, and boosts the second voltage input from second DC power supply 3 so as to output the boosted voltage to first DC power supply 2. DC-DC converter 4 may boost the first voltage input from first DC power supply 2 so as to output the boosted increased voltage to second DC power supply 3, and may step down the second voltage input from second DC power supply 3 so as to output the stepped-down voltage to first DC power supply 2.

First switch 5 is connected between first DC power supply 2 and DC-DC converter 4 and is configured to connect and disconnect first DC power supply 2 from DC-DC converter 4.

Second switch 6 is connected between second DC power supply 3 and DC-DC converter 4 and is configured to connect and disconnect between second DC power supply 3 and DC-DC converter 4.

First switch 5 and second switch 6 are, for example, semiconductor switches, such as metal-oxide semiconductor field-effect transistors (MOSFETs) or contactors, such as electromagnetic relays.

First voltage detector 51, second voltage detector 52, third voltage detector 61, and fourth voltage detector 62 are voltmeters, such as analog-to-digital (A-D) converters.

Controller 7 is configured to instruct a stepping-down control to step-down a voltage input to DC-DC converter 4 (i.e., step down the first voltage and output to the stepped-down voltage to second DC power supply 3) or a boosting control to boost a voltage input to DC-DC converter 4 (i.e., boost the second voltage and output the boosted voltage to first DC power supply 2). In addition, controller 7 is configured to instruct first switch 5 to connect and disconnect between first DC power supply 2 and DC-DC converter 4. Controller 7 is further configured to instruct second switch 6 to connect and disconnect between second DC power supply 3 and DC-DC converter 4.

Furthermore, controller 7 is configured to cause diagnosis unit 8 to measure a voltage at both ends or a potential difference between both ends of first switch 5.

In order to diagnose a turned-off performance of first switch 5, controller 7 instructs first switch 5 to be turned off and instructs second switch 6 to be turned on, and then, causes DC-DC converter 4 to perform a voltage conversion operation to discharge a charge stored in first capacitor 91 to second DC power supply. Accordingly, the embodiment provides power supply device 1 configured to diagnose the turn-off performance of first switch 5 in a short period of time.

Controller 7 and diagnosis unit 8 are configured with a memory storing a program, a processor that executes the program, an A/D converter, a timer, and the like.

An operation of power supply device 1 will be described below.

First, a normal voltage conversion operation will be described. The normal voltage conversion operation includes an operation of stepping down the first voltage of first DC power supply 2 to the second voltage and outputting the second voltage to second DC power supply 3, and an operation of boosting the second voltage of second DC power supply 3 to the first voltage and outputting the first voltage to first DC power supply 2.

For example, when vehicle 100 having power supply device 1 installed therein starts or vehicle 100 starts, controller 7 instructs first switch 5 to connect first DC power supply 2 to DC-DC converter 4. In addition, controller 7 instructs second switch 6 to connect second DC power supply to DC-DC converter 4.

First switch 5 connects first DC power supply 2 to DC-DC converter 4 in response to the instruction from controller 7. Second switch 6 connects second DC power supply 3 to DC-DC converter 4 in response to the instruction from controller 7.

The voltage input from first DC power supply 2 or second DC power supply 3 to DC-DC converter 4 is converted in response to a signal from controller 7 to DC-DC converter 4. At this moment, first capacitor 91 is charged to the first voltage of first DC power supply 2, and second capacitor 92 is charged to the second voltage of second DC power supply 3.

A diagnosis operation performed on a function to cut off external connection after the above normal voltage conversion operation will be described below.

First, diagnosis of the turned-off performance of first switch 5 will be described.

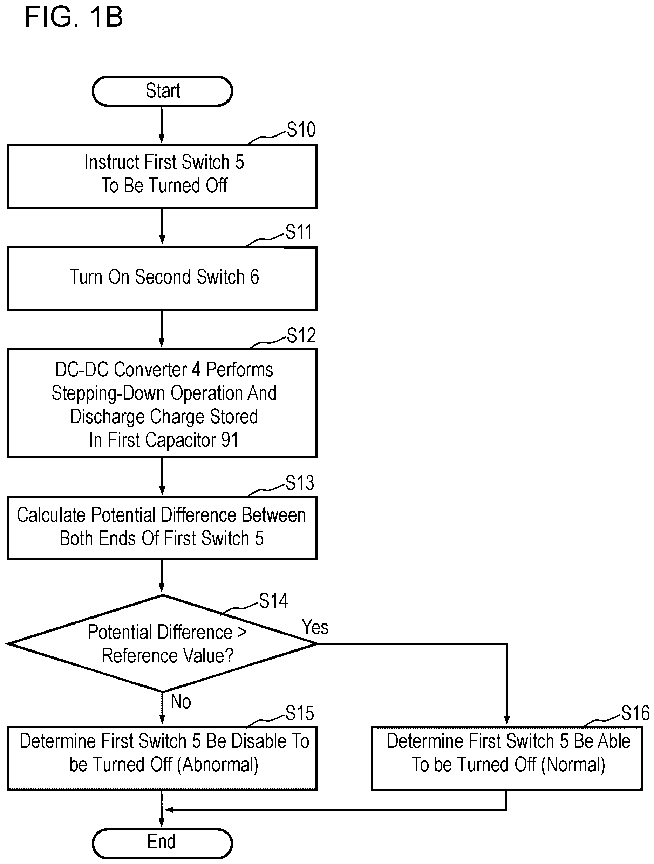

FIG. 1B is a flow chart illustrating a process of diagnosing the turned-off performance of first switch 5 (i.e., a method of diagnosing the switch) in the operation of power supply device 1 according to the embodiment.

Controller 7 instructs first switch 5 to disconnect first DC power supply from DC-DC converter 4. Controller 7 instructs first switch 5 to be turned off to disconnect first DC power supply 2 from DC-DC converter 4 (step S10).

Furthermore, controller 7 instructs second switch 6 to connect second DC power supply 3 to DC-DC converter 4. Second switch 6 connects second DC power supply 3 to DC-DC converter 4 according to the instruction from controller 7 (step S11). Steps S10 and S11 may be performed in an opposite order to FIG. 1B or may be performed simultaneously to each other.

Next, controller 7 causes DC-DC converter 4 to operate to discharge the charge stored in first capacitor 91 of DC-DC converter 4 to second DC power supply 3 (step S12). More specifically, controller 7 instructs DC-DC converter 4 to perform the stepping-down operation and discharge the charge stored in first capacitor 91 of DC-DC converter 4 to second DC power supply 3.

Next, diagnosis unit 8 measures voltages at both ends, two points, of first switch 5 by first voltage detector 51 and second voltage detector 52, and calculates a potential difference between both ends of first switch 5 (step S13). When the potential difference between both ends of first switch 5 calculated by diagnosis unit 8 is not greater than a reference value ("No" at step S14), it is confirmed that first switch 5 does not disconnect first DC power supply 2 from DC-DC converter 4, and it is thus determined that first switch 5 is abnormal, i.e., is not normal (step S15). When the potential difference between both ends of first switch 5 calculated by diagnosis unit 8 is greater than the reference value ("Yes" at step S14), it can be confirmed that first switch 5 disconnects first DC power supply 2 from DC-DC converter 4, and it is thus determined that first switch 5 is normal (step S16). As a result, the normal operation of a turned-off function of first switch 5 is determined. Controller 7 outputs a determination signal according to a normal or abnormal determination result of first switch 5 to, for example, an electronic control unit (ECU) installed in vehicle 100. The ECU performs operations (e.g., display, control) according to the determination signal.

As described above, in accordance with the embodiment, when controller 7 instructs first switch 5 to disconnect first DC power supply 2 from DC-DC converter 4, controller 7 causes DC-DC converter 4 to discharge the charge stored in first capacitor 91 connected between first switch 5 and a ground in DC-DC converter 4. Therefore, when first switch 5 is turned off, the potential difference between both ends of first switch 5 is large compared with a case of not discharging the charge. As a result, diagnosis unit 8 readily and reliably diagnoses first switch 5.

When controller 7 instructs first switch 5 to disconnect first DC power supply 2 from DC-DC converter 4, the charge stored in first capacitor 91 remains. In other words, first switch 5 is simply turned off. When diagnosis unit 8 measures the potential difference between both ends of first switch 5 in this state, the potential difference between both ends of first switch 5 is smaller than that in power supply device 1 of the present disclosure due to the charge remaining in first capacitor 91 even when first switch 5 is properly turned off. Thus, diagnosis unit 8 cannot determine whether or not first switch 5 is properly turned off.

Still more, the charge in first capacitor 91 is spontaneously discharged as time passes due to a resistor connected in parallel to the capacitor or leak current from DC-DC converter 4. Therefore, the potential difference between both ends of first switch 5 is measured after a certain time passes, and then, it may be determined whether or not first switch 5 is properly turned off. However, in power supply device 1 of the present disclosure, the charge in first capacitor 91 is actively discharged in a short period of time by controller 7 instructing DC-DC converter 4 to perform a voltage conversion after controller 7 instructs first switch 5 disconnect first DC power supply 2 from DC-DC converter 4. This configuration allows the charge stored in first capacitor 91 to be discharged in a significantly shorter period than the spontaneous discharge of the charge. As a result, it is determined, in a shorter period than the spontaneous discharge, whether or not first switch 5 is properly turned off.

Next, diagnosis of the turned-off performance of second switch 6 will be described.

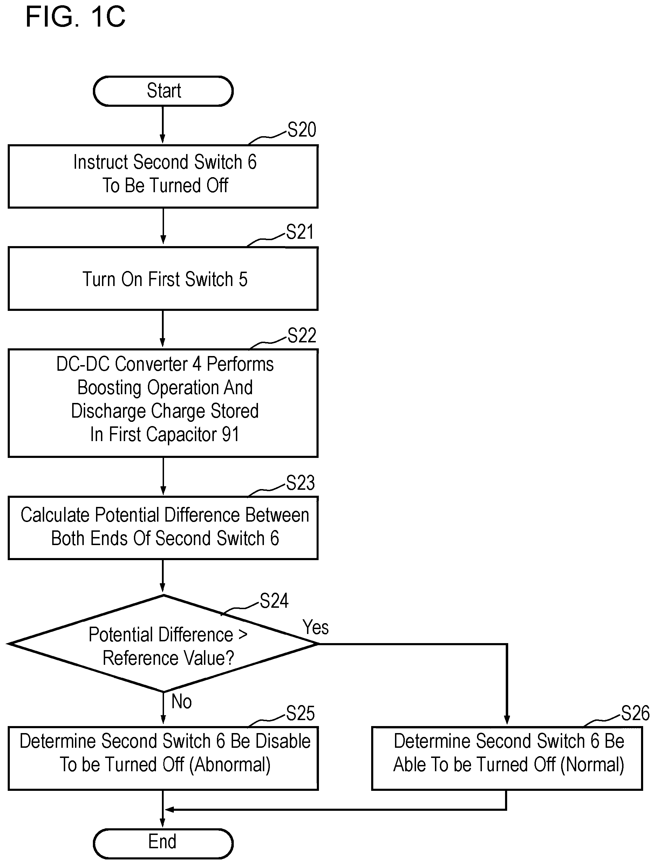

FIG. 1C is a flow chart illustrating a process of diagnosing the turned-off performance of second switch 6 (i.e., a method of diagnosing the switch) in an operation of power supply device 1 according to the embodiment.

Controller 7 instructs second switch 6 to disconnect second DC power supply 3 from DC-DC converter 4. Controller 7 instruct second switch 6 to be turned off to instruct second switch 6 to disconnect second DC power supply 3 from DC-DC converter 4 (step S20).

Furthermore, controller 7 instructs first switch 5 to connect first DC power supply 2 to DC-DC converter 4. Controller instructs first switch 5 to be turned on to instruct first switch 5 to connect first DC power supply 2 to DC-DC converter 4 (step S21). Steps S20 and S21 may be performed in an opposite order to FIG. 1C or may be performed simultaneously to each other.

Next, controller 7 causes DC-DC converter 4 to operate to discharge the charge stored in second capacitor 92 of DC-DC converter 4 to first DC power supply 2 (step S22). More specifically, controller 7 instructs DC-DC converter 4 to perform the boosting operation and to discharge the charge stored in second capacitor 92 of DC-DC converter 4 to first DC power supply 2.

Next, diagnosis unit 8 measures a voltage at both ends, two points, of second switch 6 by third voltage detector 61 and fourth voltage detector 62, and calculates a potential difference between both ends of second switch 6 (step S23). When the potential difference between both ends of second switch 6 calculated by diagnosis unit 8 is not greater than a reference value ("No" at step S24), it is confirmed that second switch 6does not disconnect second DC power supply 3 from DC-DC converter 4, and it is thus determined that second switch 6 is abnormal, i.e., is not normal (step S25). When the potential difference between both ends of second switch 6 measured by diagnosis unit 8 is greater than the reference value ("Yes" in step S24), it is confirmed that second switch 6 disconnects second DC power supply 3 from DC-DC converter 4, and it is thus determined that second switch 6 is normal (step S26). When the potential difference between both ends of second switch 6 measured by diagnosis unit 8 is not greater than a reference value ("No" in step S24), it is confirmed that second switch 6 does not disconnect second DC power supply 3 from DC-DC converter 4, and it is thus determined that second switch 6 is abnormal, i.e., is not normal (step S26). As a result, the normal operation of a turned-off function of second switch 6 is determined. Controller 7 outputs a determination signal according to a normal or abnormal determination result of second switch 6 to, for example, an electronic control unit (ECU) installed in vehicle 100. The ECU performs an operation (e.g., display, control) according to the determination signal.

As described above, in accordance with the present embodiment, when controller 7 instructs second switch 6 to disconnect second DC power supply 3 from DC-DC converter 4, controller 7 causes DC-DC converter 4 to discharge the charge stored in second capacitor 92 connected between second switch 6 and a ground in DC-DC converter 4. Therefore, when second switch 6 is turned off, the potential difference between both ends of second switch 6 is large compared with a case of not discharging the charge. As a result, diagnosis unit 8 readily and reliability diagnose second switch 6.

When controller 7 instructs second switch 6 to disconnect second DC power supply 3 from DC-DC converter 4, the charge stored in second capacitor 92 remains. In other words, second switch 6 is simply turned off. When diagnosis unit 8 measures the potential difference between both ends of second switch 6 in this state, the potential difference between both ends of second switch 6 is smaller than that of power supply device 1 of the present disclosure due to the charge remaining in second capacitor 92 even when second switch 6 is properly turned off. Thus, diagnosis unit 8 does not determine whether or not second switch 6 is properly turned off.

Still more, the charge stored in second capacitor 92 is spontaneously discharged as time passes due to a resistor connected in parallel or leak current from DC-DC converter 4. Therefore, in the prior art also, the potential difference between both ends of second switch 6 is measured after a certain time passes, it is determined whether or not second switch 6 is properly turned off. However, in power supply device 1 of the present disclosure, the charge stored in second capacitor 92 is actively discharged in a short period by controller 7 instructing DC-DC converter 4 to perform the voltage conversion after controller 7 instructs second switch 6 to disconnect second DC power supply 3 from DC-DC converter 4. Accordingly, the charge stored in second capacitor 92 is discharged in a significantly short time of time compared with spontaneous discharge of the charge. As a result, it is determined, in a short period of time compared with the prior art, whether or not second switch 6 is properly turned off.

The reference value for the potential difference between both ends of each of first switch 5 and second switch 6 is determined based on an element employed in first switch 5 and second switch 6 or a component turned-off characteristic.

First DC power supply 2 may be substituted by a capacitor. The first voltage does not necessarily be supplied from an active power supply. The capacitor may be charged by DC-DC converter 4, and a voltage after being charged may be regarded as the first voltage. This configuration allows the power supply of vehicle 100 to be constituted only by second DC power supply 3. As a result, a vehicle configuration advantageous in terms of cost, component layout, weight, and the like can be achieved.

Second DC power supply 3 may be substituted by a capacitor. The second voltage does not necessarily be supplied from an active power supply. The capacitor may be charged by DC-DC converter 4, and a voltage after being charged may be regarded as the second voltage. This configuration allows the power supply of vehicle 100 to be configured only by first DC power supply 2. As a result, a vehicle configuration advantageous in terms of cost, component layout, weight, and the like can be achieved.

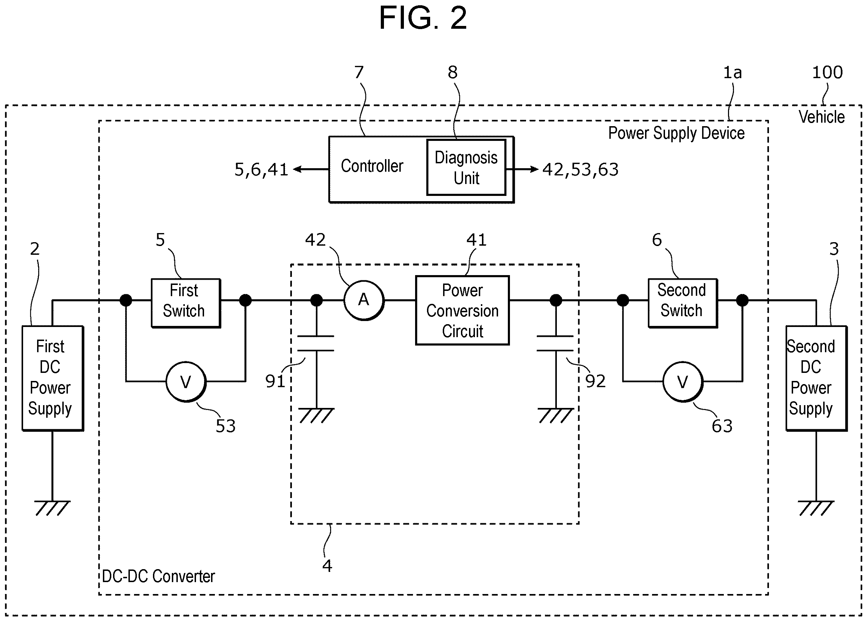

As illustrated in a configuration example of power supply device 1a according to Modification 1 of the present exemplary embodiment in FIG. 2, fifth voltage detector 53 may be provided to directly measure the potential difference between both ends of first switch 5 instead of first voltage detector 51 and second voltage detector 52 shown in FIG. 1A. Fifth voltage detector 53 is, for example, an A/D converter.

Similarly, as illustrated in FIG. 2, sixth voltage detector 63 may be provided to directly measure the potential difference between both ends of second switch 6 instead of third voltage detector 61 and fourth voltage detector 62 shown in FIG. 1A. Sixth voltage detector 63 is, for example, an A/D converter.

In accordance with the embodiment, in order to diagnose the turned-off performance of first switch 5, DC-DC converter 4 may operate to control the voltage of first capacitor 91. More specifically, controller 7 instructs first switch 5 to disconnect first DC power supply 2 from DC-DC converter 4, and then, controller 7 instructs DC-DC converter 4 to perform the voltage conversion. Here, the voltage of first capacitor 91 is controlled based on the voltage of first capacitor 91 detected by second voltage detector 52 shown in FIG. 1A, so that the voltage of first capacitor 91 can be controlled (i.e., set) to an arbitrary voltage.

When first switch 5 is turned on, first capacitor 91 is charged to close to the voltage of first DC power supply 2, and then, first switch 5 is turned off in order to reduce a rush current flowing to first switch 5 at connection.

For this purpose, in order to determine a proper turned-off function of first switch 5, when first switch 5 is turned on again after the charge of first capacitor 91 is completely discharged, first capacitor 91 is charged to the voltage of first DC power supply 2.

In contrast, when the voltage of first capacitor 91 is controlled to the arbitrary voltage not zero, a charging time before turning on first switch 5 again may be shortened.

For example, in order to cause the voltage of first capacitor 91 to the arbitrary voltage not zero, first voltage detector 51 monitors the voltage to maintain a potential difference necessary for determining the proper turn-off function of first switch 5 with respect to the voltage of second voltage detector 52. For example, the voltage of first capacitor 91 is controlled to be the voltage lower than the first voltage by a reference value for determination. This configuration minimizes the charge discharged from first capacitor 91 necessary for determining the turned-off function of first switch 5. As a result, a turned-off function determination time and a charging time before connecting first switch 5 again is shortened.

Similarly, to diagnose the turned-off performance of second switch 6, DC-DC converter 4 may operate to control the voltage of second capacitor 92. More specifically, controller 7 instructs second switch 6 to disconnect second DC power supply 3 from DC-DC converter 4, and then controller 7 instructs DC-DC converter 4 to perform the voltage conversion. Here, the voltage of second capacitor 92 is controlled based on the voltage of second capacitor 92 detected by third voltage detector 61, so that the voltage of second capacitor 92 can be controlled (i.e., set) to an arbitrary voltage.

When second switch 6 is turned on, second capacitor 92 is charged to close to the voltage of second DC power supply 3, and then second switch 6 is turned on in order to reduce a rush current flowing to second switch 6 at connection.

For this purpose, when second switch 6 is connected again after the charge of second capacitor 92 is completely discharged for determining the proper turned-off function of second switch 6, second capacitor 92 is charged to the voltage of second DC power supply 3.

In contrast, when the voltage of second capacitor 92 is controlled to be the arbitrary voltage not zero, a charging time before connecting second switch 6 again is shortened.

For example, in order to control the voltage of second capacitor 92 to the arbitrary voltage not zero, fourth voltage detector 62 monitors the voltage to maintain a potential difference necessary for determining the proper turned-off function of second switch 6 with respect to the voltage of third voltage detector 61. For example, the voltage of second capacitor 92 is controlled to be the voltage lower than the second voltage by a reference value for determination. This configuration minimizes the charge discharged from second capacitor 92 necessary for determining the turned-off function of second switch 6. As a result, a turned-off function determination time and a charging time before connecting second switch 6 again can be shortened.

Note that diagnosis unit 8 may detect current flowing in power conversion circuit 41 of DC-DC converter 4 by current sensor 42. After controller 7 instructs first switch 5 to disconnect first DC power supply 2 from DC-DC converter 4 or after controller 7 instructs second switch 6 to disconnect second DC power supply 3 from DC-DC converter 4, controller 7 instructs DC-DC converter 4 to perform the voltage conversion. Here, current of DC-DC converter 4 is controlled such that current detected by current sensor 42 becomes not greater than a predetermined current or conversion by DC-DC converter 4 is stopped when detecting the current not less than the predetermined current. This configuration prevents excess power supply or excess current flow to first DC power supply 2 or second DC power supply 3 even when the turned-off performance of first switch 5 or second switch 6 as a diagnosis target is lost.

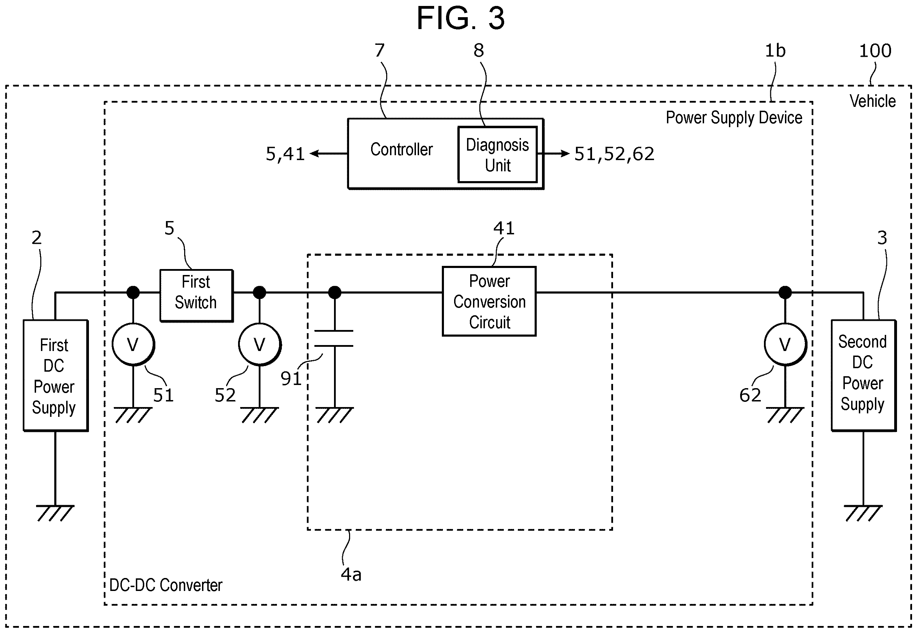

As illustrated in a configuration example of power supply device 1b according to Modification 2 of the embodiment shown in FIG. 3, the turned-off performance of first switch 5 is diagnosed even when only first switch 5 is provided without second switch 6 in the exemplary embodiment, and DC-DC converter 4a is configured only with first capacitor 91 and power conversion circuit 41.

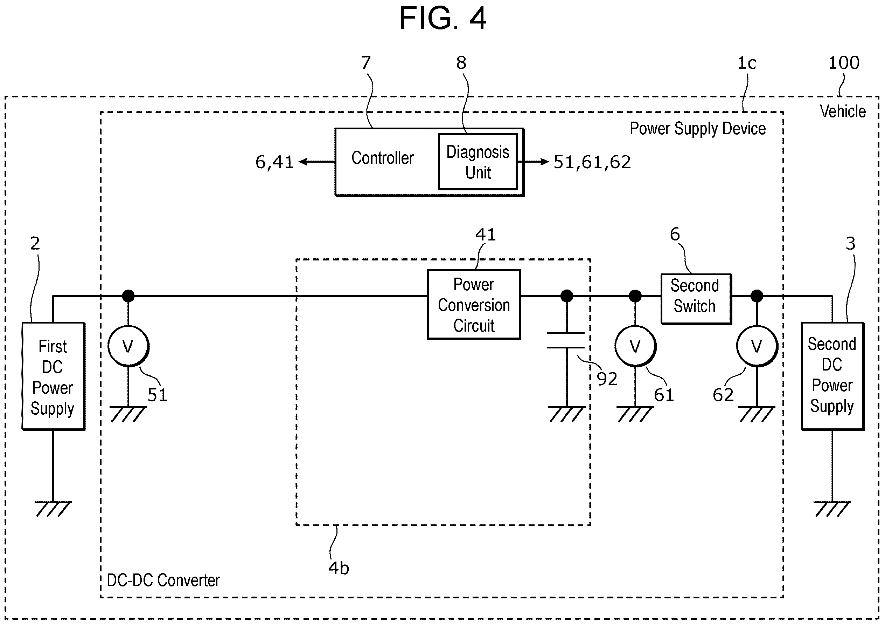

Similarly, as illustrated in a configuration example of power supply device 1c according to Modification 3 of the embodiment shown in FIG. 4, the turned-off performance of second switch 6 is diagnosed even when only second switch is provided without first switch 5 and DC-DC converter 4b is configured only with second capacitor 92 and power conversion circuit 41.

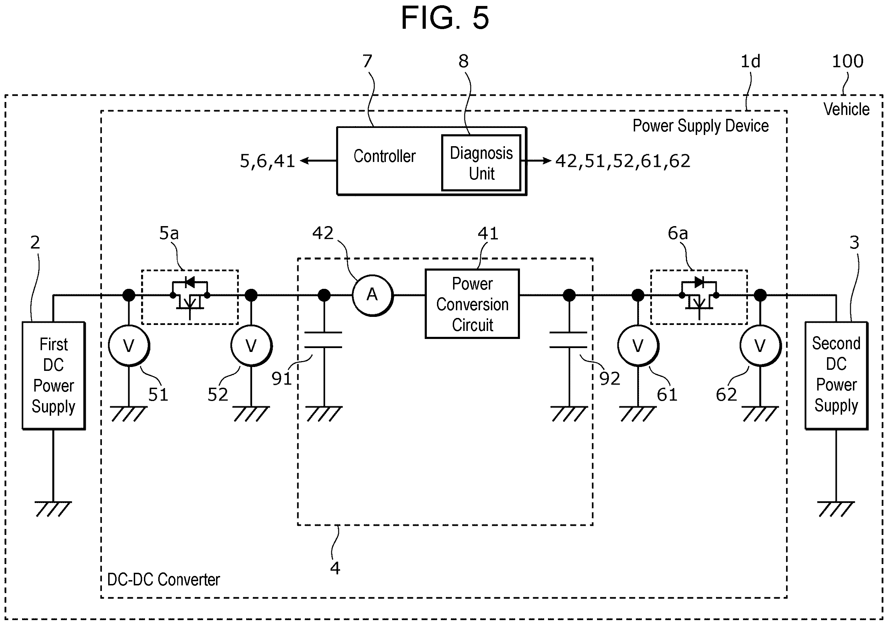

Still more, as illustrated in a configuration example of power supply device 1d according to Modification 4 of the embodiment shown in FIG. 5, the turned-off performance of first switch 5a and second switch 6a is diagnosed by employing the method similar to the above embodiment even when each of first switch 5a and second switch 6a is implemented by a single MOSFET.

Since first switch 5a is implemented by a MOSFET having a body diode with a forward direction from DC-DC converter 4 to first DC power supply 2, as illustrated, first switch 5a has a function to cut off current flowing from first DC power supply 2 to DC-DC converter 4 but does not have a function to cut off current flowing from DC-DC converter 4 to first DC power supply 2. The embodiment is also capable of diagnosing the turned-off function of first switch 5a as configured above since the voltage of first capacitor 91 decreases after turning off first switch 5a in diagnosis of the turned-off performance.

Similarly, since second switch 6a is implemented by a MOSFET having a body diode with a forward direction from DC-DC converter 4 to second DC power supply 3, as illustrated, second switch 6a has a function to cut off current flowing from second DC power supply 3 to DC-DC converter 4 but does not have a function to cut off current flowing from DC-DC converter 4 to second DC power supply 3. The embodiment is also capable of diagnosing the turned-off function of second switch 6a as configured above since the voltage of second capacitor 92 decreases after turning off second switch 6a in diagnosis of the turned-off performance.

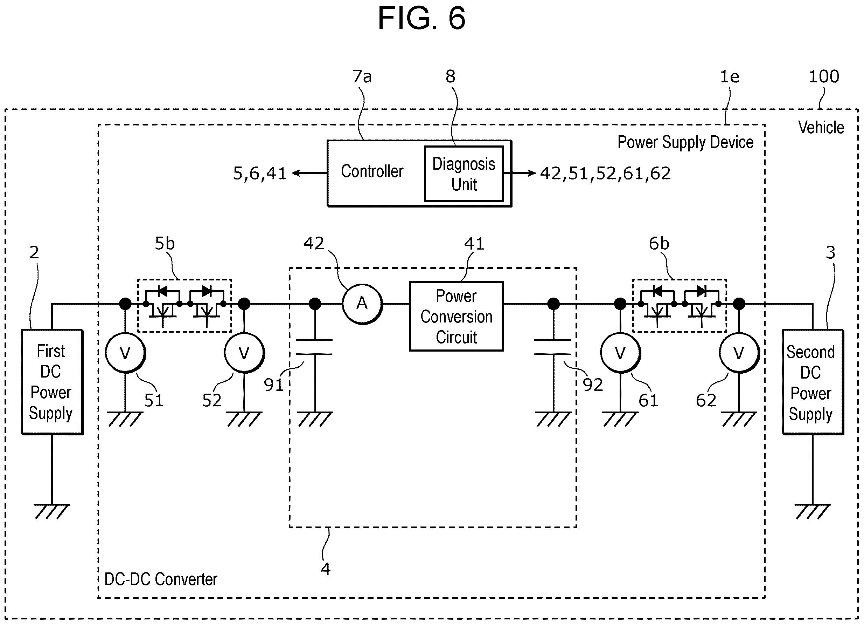

FIG. 6 illustrates a configuration example of power supply device 1e according to Modification 5 of the embodiment.

Power supply device 1e includes first DC power supply 2, second DC power supply 3, DC-DC converter 4, first switch 5b, second switch 6b, controller 7a, first voltage detector 51, second voltage detector 52, third voltage detector 61, and fourth voltage detector 62. Controller 7a includes diagnosis unit 8. Components identical to those of the exemplary embodiment are denoted by the same reference numerals, and their description will be omitted. Points that differ from the above exemplary embodiment will be mainly described.

As illustrated in FIG. 6, first switch 5b includes two MOSFETs connected in series to each other. The MOSFETs have body diodes with forward directions opposite to each other, and have a function to cut off current in both directions. Similarly, second switch 6b, as illustrated in FIG. 6, includes two MOSFETs connected in series to each other. The MOSFETs have body diodes with forward directions opposite to each other, and have a function to cut off current in both directions.

Controller 7a and DC-DC converter 4 of Modification 5 has the following function in addition to the function described in the embodiment.

In other words, in order to diagnose first switch 5b, controller 7a instructs first switch 5b to be turned off, and then, DC-DC converter 4 boosts the voltage of second capacitor 92 to convert the voltage output to first capacitor 91, thereby charging first capacitor 91.

In order to diagnose second switch 6b, controller 7a instructs second switch 6b to be turned off, and then, DC-DC converter 4 steps down the voltage of first capacitor 91 to convert the voltage output to second capacitor 92, thereby charging second capacitor 92.

Accordingly, Modification 5 provides power supply device 1e configured to diagnose, in a short period of time, the turned-off performances of first switch 5b that disconnects first DC power supply 2 from DC-DC converter 4 and second switch 6b that disconnects second DC power supply 3 from DC-DC converter 4.

Next, an entire operation of power supply device 1e will be described.

The normal voltage conversion operation is the same as the exemplary embodiment.

An operation in which an external connection is cut off after the normal voltage conversion operation will be described.

Controller 7a instructs first switch 5b to disconnect first DC power supply 2 from DC-DC converter 4. First switch 5b disconnects first DC power supply 2 from DC-DC converter 4 in response to the instruction from controller 7a. For example, controller 7a further changes a target of voltage detection and monitoring to first capacitor 91, and detects and monitors the voltage of first capacitor 91.

Next, controller 7a causes DC-DC converter 4 to operate such that the voltage of first capacitor 91 of DC-DC converter is controlled to be a voltage higher than the voltage of first DC power supply 2. More specifically, controller 7a instructs DC-DC converter 4 to perform the boosting operation, and the voltage of second DC power supply 3 is boosted by DC-DC converter 4, so that the voltage of first capacitor 91 is controlled to be the voltage higher than that of first DC power supply 2. Here, a control target of power conversion is first capacitor 91, and thus the voltage of first capacitor 91 is controlled to be an arbitrary voltage greater than zero by DC-DC converter 4.

Next, diagnosis unit 8 measures a potential difference between both ends of first switch 5b. When the potential difference between both ends of first switch 5b measured by diagnosis unit 8 is not greater than a reference value, it is confirmed that first switch 5b is unable to properly respond to the instruction from controller 7a and dose not disconnect first DC power supply 2 from DC-DC converter 4. When the potential difference between both ends of first switch 5b measured by diagnosis unit 8 is greater than the reference value, it is confirmed that first switch 5b is able to properly respond to the instruction from controller 7a and disconnects first DC power supply 2 from DC-DC converter 4. It is thus determined whether or not first switch 5b is properly disconnect first DC power supply 2 from DC-DC converter 4.

First switch 5a according to Modification 4 illustrated in FIG. 5 is implemented by a single MOSFET. Therefore, in general, first switch 5a does not have cut off current flowing in the direction from DC-DC converter 4 to first DC power supply 2 by the body diode even when first switch 5a is controlled to be turned off. Only current flowing in a direction from first DC power supply 2 to DC-DC converter 4 is cut off. In contrast, first switch 5b according to Modification 5 illustrated in FIG. 6 has a cut-off performance cutting off the current flowing in the direction from DC-DC converter 4 to first DC power supply 2. In this case, by the method in Modification 5 the cut-off performance with respect to the current flowing in the direction from DC-DC converter 4 to first DC power supply 2 is diagnosed.

The above description of the operation to cut off external connection refers to a case where controller 7a instructs to first switch 5b to disconnect first DC power supply 2 from DC-DC converter 4. However, the same operation applies to a case where controller 7a instructs second switch 6b to disconnect second DC power supply 3 from DC-DC converter 4.

That is, controller 7a instructs second switch 6b to disconnect second DC power supply 3 from DC-DC converter 4. Second switch 6b disconnects second DC power supply 3 from DC-DC converter 4 in response to the instruction from controller 7a. For example, controller 7a further changes a target of voltage detection and monitoring to second capacitor 92, and detects and monitors the voltage of second capacitor 92.

Next, controller 7a causes DC-DC converter 4 to operate such that the voltage of second capacitor 92 of DC-DC converter 4 is controlled to be a voltage higher than the voltage of second DC power supply 3. More specifically, controller 7a instructs to DC-DC converter 4 to perform the stepping-down operation, and the voltage of first DC power supply 2 is stepped down by DC-DC converter 4, so that the voltage of second capacitor 92 is controlled to be the voltage higher than that of second DC power supply 3. Here, a control target of power conversion is second capacitor 92, and thus the voltage of second capacitor 92 is controlled to be an arbitrary voltage greater than zero by existing DC-DC converter 4.

Next, diagnosis unit 8 measures a potential difference between both ends of second switch 6b. When the potential difference between both ends of second switch 6b measured by diagnosis unit 8 is not greater than the reference value, it is confirmed that second switch 6b is unable to properly respond to the instruction from controller 7a and to unable to disconnect second DC power supply 3 from DC-DC converter 4. When the potential difference between both ends of second switch 6b measured by diagnosis unit 8 is greater than the reference value, it is confirmed that second switch 6b able to properly respond to the instruction from controller 7a and to disconnect second DC power supply 3 from DC-DC converter 4. It is thus determined whether or not second switch 6b properly disconnect second DC power supply 3 from DC-DC converter 4.

Second switch 6a according to Modification 4 illustrated in FIG. 5 is implemented by a single MOSFET. Therefore, in general, second switch 6b does not have the cut-off performance with respect to current flowing in the direction from DC-DC converter 4 to second DC power supply 3 due to the body diode even when second switch 6b is controlled to be turned off. Only current flowing in the direction from second DC power supply 3 to DC-DC converter 4 is cut off. In contrast, second switch 6b according to Modification 5 illustrated in FIG. 6 has the cut-off performance with respect to the current flowing in the direction from DC-DC converter 4 to second DC power supply 3. In this case, by the method in Modification 5, the cut-off performance with respect to the current flowing in the direction from DC-DC converter 4 to second DC power supply 3 is diagnosed.

### Configuration of DC-DC converter 4

An internal circuit of DC-DC converter 4 in accordance with the embodiment will be described below, for example, and performs the following operation.

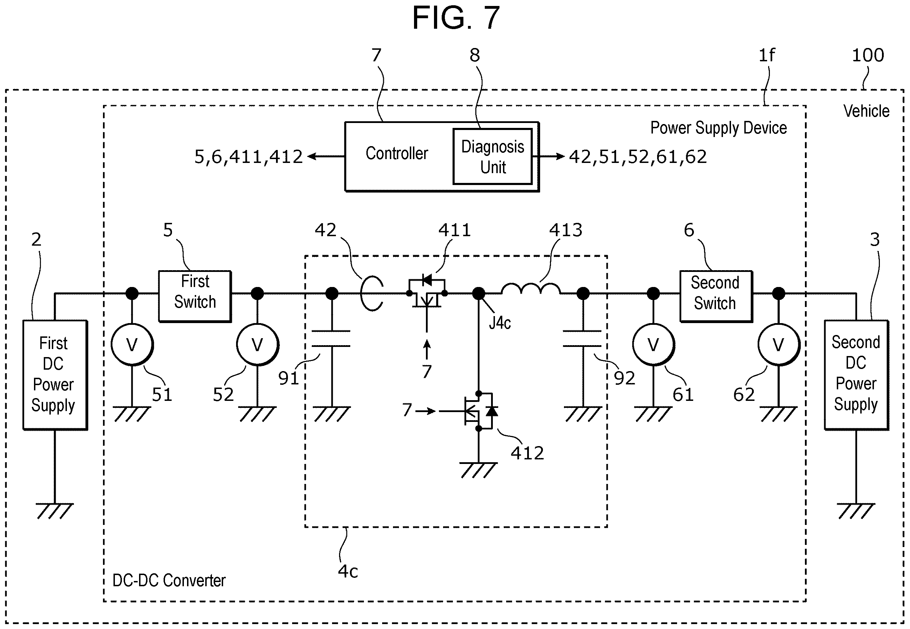

FIG. 7 illustrates a circuit of DC-DC converter 4c according to Example 1 of DC-DC converter 4 of the embodiment. The entire configuration of power supply device 1f including DC-DC converter 4c is illustrated in FIG. 7.

DC-DC converter 4c includes first switching element 411, second switching element 412, reactor 413, current sensor 42, first capacitor 91, and second capacitor 92.

As illustrated in FIG. 7, first switching element 411 and reactor 413 are connected in series to each other at node J4c in a direction from first switch 5 to second switch 6 in DC-DC converter 4c. Second switching element 412 has one end connected to node J4c of switching element 411 and reactor 413, and another end connected to a ground.

First switching element 411 is an N-channel MOSFET, and has a body diode. The body diode has an anode connected to a source of first switching element 411 and a cathode connected to a drain of first switching element 411. Second switching element 412 is an N-channel MOSFET, and has a body diode. The body diode has an anode connected to a source of second switching element 412 and a cathode connected to a drain of second switching element 412.

An operation of DC-DC converter 4c will be described below.

In power supply device 1f, DC-DC converter 4c performs the stepping-down operation when charging second DC power supply 3 from first DC power supply 2.

First switching element 411 and second switching element 412 perform switching operations under control of controller 7, and a DC voltage of first DC power supply 2 is stepped down to charge second DC power supply 3. More specifically, as an example, first switching element 411 is turned on and second switching element 412 is turned off to flow current from first DC power supply 2 to second DC power supply 3 via first switching element 411 and reactor 413. Accordingly, energy is stored in reactor 413. Still more, first switching element 411 is turned off and second switching element 412 is turned on to discharge energy stored in reactor 413 and flow current from the ground to second DC power supply via second switching element 412 and reactor 413. The above state of storing energy in reactor 413 and the above state of flowing current from the ground to second DC power supply 3 via second switching element 412 and reactor 413 are alternately repeated.

In the switching operation of first switching element 411 and second switching element 412, controller 7 feeds back the voltage of second DC power supply 3 to controller 7 to determine an on-duty of a drive signal using, for example, pulse width modulation (PWM), so as to control an output from DC-DC converter 4c.

However, controller 7 may determine the on-duty of the drive signal to first switching element 411 and second switching element 412 according to a difference with a target current value based on a current value detected by current sensor 42.

Still more, in power supply device 1f, DC-DC converter 4c performs the boosting operation when charging first DC power supply 2 from second DC power supply 3.

First switching element 411 and second switching element 412 perform switching operations under control of controller 7, and a DC voltage of second DC power supply 3 is boosted to charge first DC power supply 2. More specifically, as an example, first switching element 411 is turned off and second switching element 412 is turned on to flow current from second DC power supply 3 to the ground via reactor 413 and second switching element 412. Accordingly, energy is stored in reactor 413. Still more, first switching element 411 is turned on and second switching element 412 is turned off to discharge energy stored in reactor 413 and flow current from second DC power supply 3 to first DC power supply 2 via reactor 413 and first switching element 411. The above state of storing energy in reactor 413 and the above state of flowing current from second DC power supply 3 to first DC power supply 2 via reactor 413 and first switching element 411 are alternately repeated.

In the switching operations of first switching element 411 and second switching element 412, controller 7 feeds back the voltage of first DC power supply 2 to controller 7 to determine an on-duty of a drive signal using, for example, pulse width modulation (PWM), so as to control an output from DC-DC converter 4c.

However, controller 7 may determine the on-duty of the drive signal to first witching element 411 and second switching element 412 according to a difference of a current value detected by current sensor 42 from a target current value.

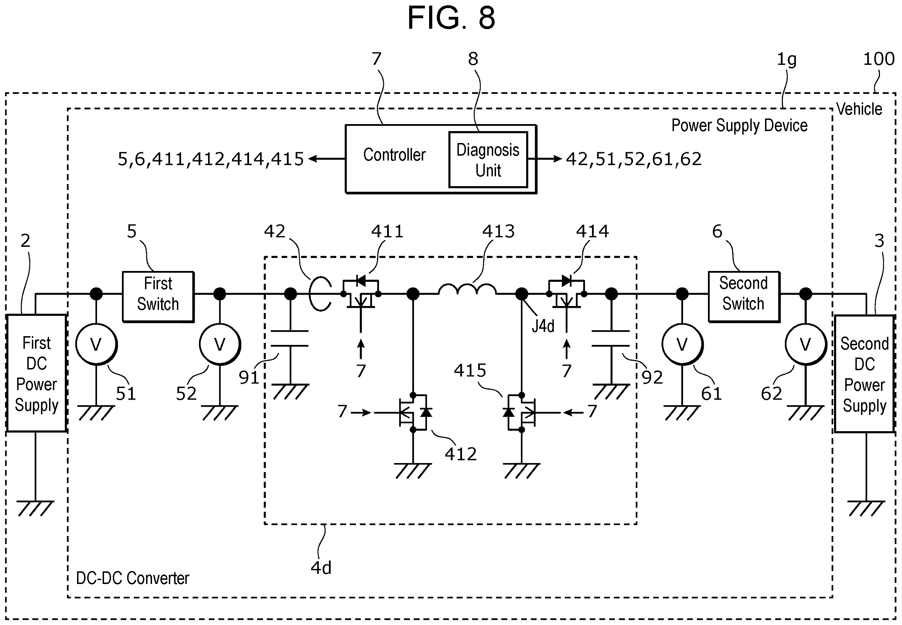

FIG. 8 illustrates a circuit of DC-DC converter 4d according to Example 2 of DC-DC converter 4 of the embodiment. An entire configuration of power supply device 1g including DC-DC converter 4d is illustrated in FIG. 8.

DC-DC converter 4d includes first switching element 411, second switching element 412, reactor 413, third switching element 414, fourth switching element 415, current sensor 42, first capacitor 91, and second capacitor 92. DC-DC converter 4d includes third switching element 414 and fourth switching element 415 added to DC-DC converter 4c of Example 1. Points that differ from DC-DC converter 4c according to Example 1 will be mainly described below.

As illustrated in FIG. 8, first switching element 411, reactor 413, and third switching element 414 are connected in series to each other at node J4d in DC-DC converter 4d in order in a direction from first switch 5 to second switch 6. Fourth switching element 415 has one end connected to node J4d of third switching element 414 and reactor 413, and has another end connected to the ground.

Third switching element 414 is an N-channel MOSFET, and has a body diode. The body diode has an anode connected to a source of third switching element 414 and a cathode connected to a drain of third switching element 414. Fourth switching element 415 is an N-channel MOSFET, and has a body diode. The body diode has an anode connected to a source of fourth switching element 415 and a cathode connected to a drain of fourth switching element 415.

An operation of DC-DC converter 4d will be described below.

In power supply device 1g, DC-DC converter 4d is configured to perform the boosting operation in addition to the stepping-down operation in response to an instruction from controller 7 when charging second DC power supply 3 from first DC power supply 2.

In order to perform the stepping-down operation, the operation similar to DC-DC converter 4c according to Example 1 is performed while third switching element 414 is turned on and fourth switching element 415 is turned off.

On the other hand, in order to perform the boosting operation, third switching element 414 and fourth switching element 415 perform the switching operation under control of controller 7 while continuously turning on first switching element 411 and turning off second switching element 412 so as to boost the DC voltage of first DC power supply 2 and charge second DC power supply 3. More specifically, as an example, third switching element 414 is turned off and fourth switching element 415 is turned on while continuously turning on first switching element 411 and turning off second switching element 412, so that current flows from first DC power supply 2 to the ground via first switching element 411, reactor 413, and fourth switching element 415. As a result, energy is stored in reactor 413. Still more, third switching element 413 is turned on and fourth switching element 415 is turned off while continuously turning on first switching element 411 and turn off second switching element 412, so that current flows from first DC power supply 2 to second DC power supply 3 via first switching element 411, reactor 413, and third switching element 414 by discharging energy stored in reactor 413. The above state of storing energy in reactor 413 and the above state of current flowing from first DC power supply 2 to second DC power supply 3 via first switching element 411, reactor 413, and third switching element 414 are alternately repeated.

In order to diagnose the turned-off performance of first switch 5 of power supply device 1g according to Example 2, similar to the embodiment, controller 7 instructs first switch 5 to be turned off and instructs second switch 6 to be turned on, and then, DC-DC converter 4d performs the voltage conversion operation so as to discharge the charge in first capacitor 91 to second DC power supply 3. Accordingly, power supply device 1 diagnoses the turned-off performance of first switch 5 in a short period of time.

In the switching operations of third switching element 414 and fourth switching element 415, controller 7 feeds back the voltage of second DC power supply 3 to controller 7 to determine an on-duty of a drive signal using, for example, pulse width modulation (PWM), so as to control an output from DC-DC converter 4d.

However, controller 7 may determine the on-duty of the drive signal to third switching element 414 and fourth switching element 415 according to the difference of the current value detected by current sensor 42 from a target current value.

Still more, in order to charge from second DC power supply 3 to first DC power supply 2 of power supply device 1g, DC-DC converter 4d may perform the stepping-down operation in addition to the boosting operation in response to the instruction from controller 7.

To perform the boosting operation, the operation similar to DC-DC converter 4c according to Example 1 is performed while continuously turning on third switching element 414 and turning off fourth switching element 415.

On the other hand, in order to perform the stepping-down operation, third switching element 414 and fourth switching element 415 performs the switching operation under control of controller 7 while continuously turning on first switching element 411 and turning off second switching element 412, so as to step down DC voltage of second DC power supply 3 to charge first DC power supply 2. More specifically, as an example, third switching element 414 is turned on and fourth switching element 415 is turned off while continuously turning on first switching element 411 and turning off second switching element 412, so that current flows from second DC power supply 3 to first DC power supply 2 via third switching element 414, reactor 413, and first switching element 411. As a result, energy is stored in reactor 413. Still more, third switching element 414 is turned off and fourth switching element 415 is turned on while continuously turning on first switching element 411 and turning off second switching element 412, so that current flows from the ground to first DC power supply 2 via fourth switching element 415, reactor 413, and first switching element 411 by discharging energy stored in reactor 413. The above state of storing energy in reactor 413 and the above state of flowing current from the ground to first DC power supply 2 via fourth switching element 415, reactor 413, and first switching element 411 are alternately repeated.

In order to diagnose the turned-off performance of second switch 6 of power supply device 1g according to Example 2, similar to the embodiment, controller 7 instructs second switch 6 to be turned off and instructs first switch 5 to be turned on, and then DC-DC converter 4d performs the voltage conversion operation so as to discharge the charge stored in second capacitor 92 to first DC power supply 2. Accordingly, power supply device 1 diagnoses the turned-off performance of second switch 6 in a short period of time.

In the switching operation of third switching element 414 and fourth switching element 415, controller 7 feeds back the voltage of first DC power supply 2 to controller 7 to determine an on-duty of a drive signal using, for example, pulse width modulation (PWM), so as to control an output from DC-DC converter 4d.

However, controller 7 may determine the on-duty of the drive signal to third switching element 414 and fourth switching element 415 according to the difference of the current value detected by current sensor 42 from the target current value.

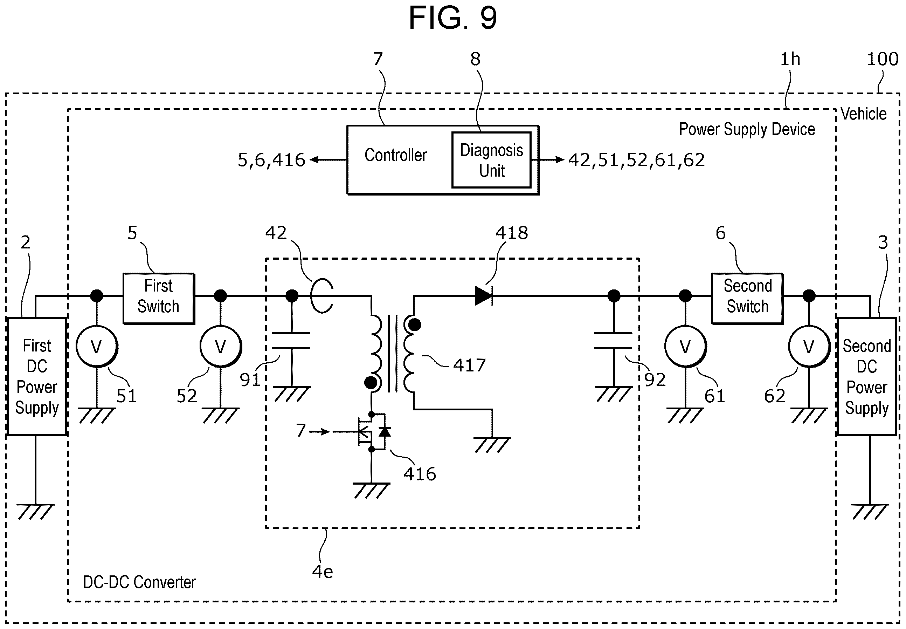

FIG. 9 illustrates a circuit of DC-DC converter 4e according to Example 3 of the exemplary embodiment. An entire configuration of power supply device 1h including DC-DC converter 4e is illustrated in FIG. 9.

DC-DC converter 4e includes fifth switching element 416, transformer 417, diode 418, current sensor 42, first capacitor 91, and second capacitor 92.

As illustrated in FIG. 9, a primary winding of transformer 417 and switching element 416 are connected in series to each other in an order in a direction from fist switch 5 in DC-DC converter 4e. Fifth switching element 416 is an N-channel MOSFET having a grounded source and a drain connected to the primary winding of transformer 417, and has a body diode. The body diode has an anode connected to a source of fifth switching element 416 and a cathode connected to a drain of fifth switching element 416.

A secondary winding of transformer 417 has one end grounded and another end connected to an anode of diode 418. Diode 418 has a cathode connected to second switch 6.

An operation of DC-DC converter 4e will be described below.

DC-DC converter 4e charges second DC power supply 3 from first DC power supply 2. To charge second DC power supply 3 from first DC power supply 2 of power supply device 1h, DC-DC converter 4e performs the boosting and stepping-down operations according to an instruction from controller 7. The boosting operation or stepping-down operation is determined based on a winding ratio of transformer 17, an on-duty of a control signal from controller 7 to, e.g., fifth switching element 416.

In order to charge second DC power supply 3 from first DC power supply 2, fifth switching element performs the switching operation under control of controller 7, and the DC voltage of first DC power supply 2 is boosted or stepped down to charge second DC power supply 3. More specifically, as an example, an alternating-current (AC) voltage is generated in the secondary winding of transformer 417 by intermittent current flowing to the primary winding of transformer 417 due to the switching of fifth switching element 416. The AC voltage is converted to a DC voltage by half-wave rectification by diode 418 and smoothing by second capacitor 92, and the DC voltage is output to second DC power supply 3.

To diagnose the shutoff performance of first switch 5 in power supply device 1h according to Example 3, similar to the exemplary embodiment, controller 7 issues the instruction to first switch 5 to shut off and the instruction to second switch 6 to connect, and then DC-DC converter 4e performs the voltage conversion operation to discharge the charge of first capacitor 91 to second DC power supply 3. Accordingly, power supply device 1 can diagnose the shutoff performance of first switch 5 in a short period of time.

In the switching operation of fifth switching element 416, controller 7 feeds back the voltage of second DC power supply 3 to controller 7 to determine an on-duty of a drive signal using, for example, pulse width modulation (PWM), so as to control an output from DC-DC converter 4e.

Controller 7 may determine the on-duty of the drive signal to fifth switching element 416 according to the difference of the current value detected by current sensor 42 from the target current value.

As described above, power supply device 1 according to the embodiment, modifications, and examples is the power supply device configured to be connected between first DC power supply 2 and second DC power supply 3. First DC power supply 2 is configured to supply and hold the first voltage. Second DC power supply 3 is configured to supply and hold the second voltage. The power supply device includes first switch 5 having one end connected to first DC power supply 2, first capacitor 91 connected to another end of first switch 5, DC-DC converter 4, and controller 7. DC-DC converter 4 is configured to perform at least one of: the first operation of converting the voltage stored in first capacitor 91 to the second voltage and outputting the second voltage to second DC power supply 3; or the second operation of converting the second voltage supplied and held by second DC power supply 3 to the third voltage and outputting the third voltage to first capacitor 91. Controller 7 is configured to control DC-DC converter 4 and first switch 5 and detect the potential difference between both ends of first switch 5. Controller 7 is configured to instruct the first switch 5 to be turned off and cause DC-DC converter 4 to perform the first operation or the second operation, and then detects the potential difference. When the potential difference detected is greater than the first reference potential difference, controller 7 is configured to determine that first switch 5 is normal.

Since DC-DC converter 4 performs the first operation or the second operation after first switch 5 is turned off in the diagnosis of first switch 5, the potential difference between both ends of first switch 5 increases in a short period, compared with the prior art, when the turned-off performance of first switch 5 is normal. Accordingly, the present disclosure provides the power supply device configured to diagnose, in a short period of time, the turned-off performance of the switch provided between the input side or the output side and the DC-DC converter included in the power supply device.

Here, DC-DC converter 4 may perform the stepping-down operation or the boosting operation as the first operation or the second operation. Accordingly, the power supply device performs a power conversion between first DC power supply 2 and second DC power supply 3 having various voltages.

DC-DC converter 4 may include current sensor 42 configured to detect current flowing in DC-DC converter 4. DC-DC converter 4 may perform at least one of the first operation or the second operation under control based on the current detected by current sensor 42.

For example, when the current detected by current sensor 42 is not less than a predetermined value, it is determined to be abnormal, and DC-DC converter 4 may stop the at least the first operation or the second operation.

DC-DC converter 4 may charge first capacitor 91 with arbitrary third voltage by the first operation or the second operation while first switch 5 is turned off. This configuration suppresses an excessively large potential difference between both ends of first switch 5 in the diagnosis of first switch 5, and thus, reduces time necessary for recovering the voltage of first capacitor 91 at completing the diagnosis.

Controller 7 may step down the voltage of first capacitor 91 to be lower than the first voltage by causing DC-DC converter 4 to perform the first operation after first switch 5 is turned off. In the diagnosis of first switch 5, the cut-off performance cutting off current flowing in a direction from a terminal connected to first DC power supply 2 to a terminal connected to first capacitor 91 is diagnosed in addition to the diagnosis of the turned-off performance of first switch 5 in a short period of time compared with the prior art.

Controller 7 may boost the voltage of first capacitor 91 to be larger than the first voltage by causing DC-DC converter 4 to perform the second operation after first switch 5 is turned off. In the diagnosis of first switch 5, the cut-off performance to cut off current flowing in a direction from the terminal connected to first capacitor 91 to the terminal connected to first DC power supply 2 is diagnosed in addition to the diagnosis of the turned-off performance of first switch 5 in a short period compared with the prior art.

Power supply device 1 may further include second switch 6 having one end connected to second DC power supply 3. DC-DC converter 4 may further include second capacitor 92 connected to another end of second switch 6. Controller 7 may be further configured to turn off second switch 6 and cause DC-DC converter 5 to perform the first operation or the second operation, and then detect a potential difference between both ends of second switch 6. Controller 7 may determine that second switch 6 is normal when the potential difference detected is greater than the second reference potential difference.

As a result, second switch 6 is diagnosed similarly to first switch 5 in addition to the diagnosis of first switch 5.

In a method of diagnosing a switch according to the exemplary embodiment, modifications, and examples, first switch 5 included in power supply device 1 and connected between first DC power supply 2 and second DC power supply 3. First DC power supply 2 supplies and holds the first voltage. Second DC power supply 3 supplies and holds the second voltage. First switch 5 has one end connected to first DC power supply 2. Power supply device 1 includes DC-DC converter 4 configured to perform at least one of: the first operation of converting the voltage stored in first capacitor 91 to the second voltage and outputting the second voltage to second DC power supply 3; or the second operation of converting the second voltage supplied and held by second DC power supply 3 to the third voltage and outputting the third voltage to first capacitor 91. In the diagnosis method, both ends of first switch 5 are disconnected from each other (step S10) and DC-DC converter 4 performs the first operation or the second operation (step S12), and then, the potential difference between both ends of first switch 5 is detected (step S13). When the detected potential difference is greater than the first reference potential difference ("No" at step S14), it is determined that first switch 5 is normal (step S16).

Since first switch 5 is turned off and then DC-DC converter 4 performs the first operation or the second operation in the diagnosis of first switch 5, the potential difference between both ends of first switch 5 increases in a short period compared with the prior art when the turned-off performance of first switch 5 is normal. The present disclosure thus provides achieves the switch diagnosis method that diagnoses, in a short period of time, the turned-off performance of the switch provided between the input side or the output side and the DC-DC converter included in the power supply device.

The power supply device and the switch diagnosis method of the present disclosure are described above with reference to the exemplary embodiment, modifications, and examples. However, the present disclosure is not limited by these exemplary embodiment, modifications, and concrete examples. Various modifications made to the exemplary embodiment, modifications, and examples or other exemplary embodiments configured by combining a part of the components of the exemplary embodiment, modifications, or examples by those skilled in the art are all embraced in the scope of the present disclosure without departing from the gist of the present disclosure.

### INDUSTRIAL APPLICABILITY

A power supply device according to the present disclosure is configured to be between two DC power supplies to perform a voltage conversion. More specifically, the power supply device diagnoses, in a short period, the turned-off performance of a switch provided between the input side or the output side and a DC-DC converter included in the power supply device, and is widely applicable to, for example, an on-vehicle power conversion device for preforming power conversion between a battery and a capacitor.

### REFERENCE MARKS IN THE DRAWINGS

1, 1a-1h power supply device
2 first DC power supply
3 second DC power supply
4, 4a-4e DC-DC converter
41 power conversion circuit
411 first switching element
412 second switching element
413 reactor
414 third switching element
415 fourth switching element
416 fifth switching element
417 transformer
418 diode
42 current sensor
5, 5a, 5b first switch
51 first voltage detector
52 second voltage detector
53 fifth voltage detector
6, 6a, 6b second switch
61 third voltage detector
62 fourth voltage detector
63 sixth voltage detector
7, 7a controller
8 diagnosis unit
91 first capacitor
92 second capacitor
100 vehicle

## Claims

1. A power supply device configured to be connected between a first direct-current (DC) power supply and a second DC power supply, the first DC power supply being configured to supply and hold a first voltage, the second DC power supply being configured to supply and hold a second voltage, the power supply device comprising:
a first switch having one end connected to the first DC power supply;
a DC-DC converter including a first capacitor connected to another end of the first switch; and
a controller configured to control the DC-DC converter and the first switch and detect a potential difference between the one end and the another end of the first switch, wherein
the DC-DC converter is configured to perform at least one of:
a first operation converting a voltage stored in the first capacitor to the second voltage and outputting the second voltage to the second DC power supply; or
a second operation of converting the second voltage supplied and held by the second DC power supply to a third voltage, and outputting the third voltage to the first capacitor, and
the controller is configured to:
detect the potential difference after instructing the first switch to be turned off and after causing the DC-DC converter to perform the first operation or the second operation; and
determine that the first switch is normal when the potential difference detected is greater than a first reference potential difference.

2. The power supply device of claim 1, wherein the controller is configured to determine that the first switch is abnormal when the potential difference detected is not greater than the first reference potential difference.

3. The power supply device of claim 1 or 2, wherein the DC-DC converter is configured to perform a stepping-down operation as the first operation or the second operation.

4. The power supply device of claim 1 or 2, wherein the DC-DC converter performs a boosting operation as the first operation or the second operation.

5. The power supply device of any one of claims 1 to 4, wherein the DC-DC converter includes a current sensor configured to detect current flowing in the DC-DC converter.

6. The power supply device of claim 5, wherein the DC-DC converter is configured to perform the at least one of the first operation or the second operation under control based on the current detected by the current sensor.

7. The power supply device of claim 6, wherein the DC-DC converter is configured to stop the at least one of the first operation or the second operation when the current detected by the current sensor is greater than or equal to a predetermined current.

8. The power supply device of any one of claims 1 to 7, wherein the DC-DC converter is configured to charge the first capacitor to the third voltage by the first operation or the second operation while the first switch is turned off, the third voltage being an arbitrary voltage.

9. The power supply device of any one of claims 1 to 8, wherein the controller is configured to step down the voltage of the first capacitor to be smaller than the first voltage by causing the DC-DC converter to perform the first operation after instructing the first switch to be turned off.

10. The power supply device of any one of claims 1 to 8, wherein the controller is configured to boost the voltage of the first capacitor to be larger than the first voltage by causing the DC-DC converter to perform the second operation after instructing the first switch to be turned off.

11. The power supply device of any one of claims 1 to 10, further comprising
a second switch having one end connected to the second DC power supply, wherein
the DC-DC converter further includes a second capacitor connected to another end of the second switch, and
the controller is configured to:
detect a potential difference between both ends of the second switch after instructing the second switch to be turned off and after causing the DC-DC converter to perform the first operation or the second operation, and
determine that the second switch is normal when the potential difference detected is greater than a second reference potential difference.

12. A method of diagnosing a power supply device connected between a first DC power supply and a second DC power supply, the first DC power supply supplying holding a first voltage, the second DC power supply supplying and holding a second voltage, the diagnosis method comprising:
providing the power supply device including
a switch having one end connected to the first DC power supply, and
a DC-DC converter including a first capacitor connected to another end of the switch, the DC-DC converter being configured to perform at least one of:
a first operation of converting a voltage stored in the first capacitor to the second voltage and outputting the second voltage to the second DC power supply; or
a second operation of converting the second voltage supplied and held by the second DC power supply to a third voltage and outputting the third voltage to the first capacitor;
detecting a potential difference between the one end and the another end of the switch after instructing the switch to be turned off and after causing the DC-DC converter to perform the first operation or the second operation; and
determining that the switch is normal when the potential difference detected is greater than a reference potential difference.

13. The diagnosis method of claim 12, further comprising determining that the first switch is abnormal when the potential difference detected is not greater than the reference potential reference.
